# EUROPEAN PATENT SPECIFICATION

(11) **EP 3 067 437 B1**
(45) Date of publication and mention of the grant of the patent: **23.11.2022**
(21) Application number: 16159684.6
(22) Date of filing: 10.03.2016
(51) Int. Cl.: C23C 14/00, C23C 14/56, C23C 14/08, C23C 14/20

(54) **IMPROVED VACUUM COATING METHOD**
VERBESSERTES VAKUUMBESCHICHTUNGSVERFAHREN
MÉTHODE DE REVÊTEMENT SOUS VIDE AMÉLIORÉE

(30) Priority: 10.03.2015 GB 201504061; 03.07.2015 GB 201511671
(43) Date of publication of application: 14.09.2016
(60) Divisional application: 21170452.3
(73) Proprietor: Bobst Manchester Limited, Heywood, Lancashire OL10 2TL (GB)
(72) Inventor: COPELAND, Nicholas John, Staybridge, Cheshire SK15 2TX (GB); SEREDNYCKY, Stefan Ivan, Prestwich, Manchester M25 3AQ (GB)
(74) Representative: ip21 Ltd

(56) References cited:
- WO-A1-2012/146310
- JP-A- H1 053 868
- JP-A- S62 228 461
- JP-A- 2007 270 251
- JP-A- 2009 197 340
- JP-A- 2013 189 701
- JP-A- 2013 234 364

## Description

### Field of the Invention

The invention relates to methods of operating a vacuum coater.

### Background to the Invention

Currently vacuum coating machines for coating web substrates exist. The closest prior art known to the applicant are their own prior art vacuum coaters.

Disadvantages with the prior art include problems achieving high metal adhesion. Current standard levels on standard commodity grade films (corona / plain PET, OPP/CPP), used for flexible food packaging or other applications, are in the range of 0.1-0.3 N/15mm.

Various ways to increase metal adhesion in the prior art involve using expensive, chemically treated film, however these have a high margin which prevents their use for lower cost applications. Other techniques include the use of in-line, in-vacuum plasma pre-treatments to promote metal adhesion but these techniques comprise a far higher technical complexity at much higher capital costs and achieve a low standard of metal bond strength.

One of the objects of the invention, therefore, is to greatly improve the metal adhesion to the web providing an improved quality of the finished product, enabling the final metallised film to be used for higher margin packaging structures and applications. Further objects of the invention will become apparent in the detailed aspects of the following sections and will be apparent to the person skilled in the art of vacuum coating.

The following prior art documents are acknowledged: JP2009263740, JPH05339704, JPS6126941, EP1522606, JPS5788531, US5759710, JPH10330915, WO2012/146310, EP0156625, JPH0798868, JP2013234364 and JP2007270251. JP2013234364 D1 discloses a system for depositing fully transparent aluminium oxide layers consequently the configuration and structure of the coater differ fundamentally from those proposed in this application.

A generic method of operating a vacuum coater for coating a web with a succession of aluminium oxide and aluminium metal is known from JP S62 228461 A.

### Summary of the invention

In its broadest independent aspect, the invention provides a method of operating a vacuum coater as defined in claim 1.

By contrast with the prior art referenced above, the approach reverses conventional thinking by increasing adhesion of the metal layer whilst achieving an opaque coating. The prior art approaches seek to only produce transparent coatings of Aluminium oxide and simply fail to even consider the problem of poor adhesion and how this might be solved. This configuration is particularly advantageous because it provides a metallised coated substrate with the high adhesion which enables its use for higher margin packaging structures. The position of the oxygen injector in particular allows for the creation of an oxygen rich metal oxide layer between the web surface and the remaining depth of the metal layer which may increase the adhesion to levels greater than 5N/15mm. In preferred embodiments, the webs have experienced no chemical pre-treatments to achieve the vastly improved adhesion properties. This approach therefore offers a much more straightforward process to achieve high adhesion of opaque coating on webs.

The resulting coated webs also benefit from high surface tension which is retained over extended periods of time thus also in preferred embodiments avoiding the requirement of a primer when inks and adhesives are applied to the coated webs in further post-coating manufacturing processes.

Moreover this configuration simplifies the overall process as there may be just one step rather than multiple steps. In other words, embodiments of the invention provide a single pass in-line in-vacuum technique achieving extremely high metal adhesion between the underlying web substrate and the aluminium vacuum deposited layer. The position of the oxygen injector also improves the optical uniformity and manages to obtain sufficient metal opacity which may be required for providing a UV light barrier to light sensitive products for which the packaging may be used.

In addition to these advantages, a further significant advantage arises in embodiments of the invention. In particular, the surface tension of the coated web is much greater for a coated web according to the inventive coating method than one which would not be formed in this manner. In particular embodiments, the Dyne level of the surface of the coated web in accordance to the invention is at least 10% higher and often 20% higher. For example, a coated web produced with only an opaque layer of metal would achieve a Dyne level of 40-45 whereas the Dyne level of a coated web of the invention would achieve a Dyne level of 55 (1 Dyne is 1 mN/m). Over time, at least a 10% superior Dyne level is also maintained. In one embodiment, such improvements have been established using a web of cast polypropylene (CPP) and a flow rate between 350 and 450 scm³ of oxygen when the selected metal was aluminium. In another embodiment, the Dyne level is approximately 20% higher following the inventive method even after a period of 85 days.

Furthermore, the web may be of a standard commodity grade film such as Corona, PE (Polyethylene), plain PET (Polyethylene terephthalate) or OPP/CPP (Polypropylene / Cast Polypropylene). The web may also be an aluminium foil.

A further advantage of the particular configuration is that the bond strength between the metallised film surface and a further laminating layer is increased.

In a further subsidiary aspect, the web is laminated after said deposition. In this configuration, the bond strength between the metal surface of the metallised film and a laminated layer is also increased.

In a further subsidiary aspect, the deposited layer of metal oxide is thinner than the deposited layer of metal. In a further subsidiary aspect, the thickness of the metal oxide layer is 5 to 15 nm and/or the thickness of the metal layer is 15 to 45 nm. The metal is aluminium. In a further subsidiary aspect, the thickness of metal oxide is about 1/3 of the total thickness of the deposit whilst the thickness of the metal is about 2/3 of the total thickness of the deposit.

In a further subsidiary aspect, the deposited metal layer is at least 60% of the depth of the combined depth of the metal oxide layer and said metal layer.

According to claim 1, the oxygen injector is positioned at a tangent to said drum. This configuration is particularly advantageous because, in use, this specific location provides an advantageous location for a metal oxide layer to form to provide advantageous metal adhesion levels. Moreover, this position is important as it prevents an increase in pressure.

In a further subsidiary aspect, the vacuum coater comprises a shutter between the oxygen injector and the deposition source. This configuration is particularly advantageous because the shutter can prevent the nozzle of the oxygen injector from becoming blocked by deposition from the deposition material.

Preferably, the shutter is displaceable to regulate the aperture for the passage of the evaporated metal.

In a further subsidiary aspect, the oxygen injector comprises a plurality of outlets.

This configuration is particularly advantageous because it enables the oxygen to be injected directly on to the substrate with maximum uniformity and control.

In a further subsidiary aspect, the plurality of outlets are distributed across the entire width of the web. This configuration is particularly advantageous because it enables the oxygen to be injected evenly directly on to the substrate for the entire width of the substrate to produce a high level of uniformity.

In a further subsidiary aspect, the outlets are formed of individual pipes at a pitch of 100mm. This configuration is particularly advantageous because the results have shown that this size provides an advantageous oxygen flow rate for forming the oxygen rich metal oxide layer.

The oxygen flow rate is also advantageous to minimise 'film curl' based on the internal stress in the coating.

In an alternative subsidiary aspect, the oxygen injector comprises a slit extending widthwise to distribute oxygen across at least part of the width of the web. This configuration is particularly advantageous for the industrial size that will be required for particular coaters. It provides advantageous scalability and simplification of structure.

In a further alternative subsidiary aspect, the oxygen injector is wedge-shaped in cross-section and the oxygen exits the injector through an aperture located at the narrowing extremity of the wedge. This configuration is particularly advantageous in terms of increasing the velocity of the oxygen exiting the injector. It also allows the oxygen to be appropriately directed onto the web.

In a further subsidiary aspect, the flow rate of oxygen is within the range of 300-500 scm³ (standard centimetre cubed) per minute per 100 mm of the web's width. This configuration is particularly advantageous because it achieves a relatively thin oxygen-rich metal oxide layer which in combination with the outer metal layer combines both high adhesion and opacity.

In a further subsidiary aspect, the flow rate of oxygen is within the range of 350-400 scm³ per minute per 100mm of the web's width. This configuration is particularly advantageous because it promotes both high levels of metal adhesion and the amount of oxygen being injected for each increment provides uniformity. The gas volumetric flow has been developed and characterised to specifically understand its effective operating window.

In a further subsidiary aspect, the web comprises polyethylene (PE).

In a further subsidiary aspect, the web comprises polyethylene terephthalate (PET).

In a further subsidiary aspect, the web comprises biaxially oriented polypropylene (BOPP).

In a further subsidiary aspect, the web comprises cast polypropylene (CPP).

In a further subsidiary aspect, the flow rate of oxygen is within the range of 200-600 scm³ per minute per 100mm of the web's width and the web comprises polyethylene terephthalate (PET). Advantageously high adhesion rates are obtained for PET within this range.

In a further subsidiary aspect, the web is coated to achieve an optical density (OD) of between 2.2 and 2.6 and the flow rate of oxygen is within the range of 200 and 400 scm³ per minute per 100mm of the web's width.

In a further subsidiary aspect, the web is coated to achieve an optical density (OD) of between 2.2 and 2.6 and the flow rate of oxygen is within the range of 275 and 325 scm³ per minute per 100mm of the web's width.

In a further subsidiary aspect, the web is coated to achieve an optical density (OD) of 2.4 and the flow rate of oxygen is 300 scm³ per minute per 100mm of the web's width.

In a further subsidiary aspect, the web is coated to achieve an optical density (OD) of between 2.6 and 3 and the flow rate of oxygen is within the range of 325 and 425 scm³ per minute per 100mm of the web's width.

In a further subsidiary aspect, the web is coated to achieve an optical density (OD) of 2.8 and the flow rate of oxygen is between 375 and 425 scm³ per minute per 100mm of the web's width.

In a further subsidiary aspect, the web is coated to achieve an optical density (OD) of between 3 and 3.4 and the flow rate of oxygen is within the range of 400 and 500 scm³ per minute per 100mm of the web's width.

In a further subsidiary aspect, the web is coated to achieve an optical density (OD) of 3.2 and the flow rate of oxygen is between 450 and 500 scm³ per minute per 100mm of the web's width.

In a further subsidiary aspect, the flow rate of oxygen is within the range of 100-300 scm³ per minute per 100mm of the web's width and the web comprises biaxially oriented polypropylene (BOPP).

In a further subsidiary aspect, the web is coated to achieve an optical density (OD) of between 2 and 2.4 and the flow rate of oxygen is within the range of 150 and 200 scm³ per minute per 100mm of the web's width.

In a further subsidiary aspect, the web is coated to achieve an optical density (OD) of 2.2 and the flow rate of oxygen is within the range of 150 and 200 scm³ per minute per 100mm of the web's width.

In a further subsidiary aspect, the flow rate of oxygen is within the range of 300-500 scm3 per minute per 100mm of the web's width and the web comprises cast polypropylene (CPP).

In a further subsidiary aspect, the web is coated to achieve an optical density (OD) of between 2 and 2.4 and the flow rate of oxygen is within the range of 300 and 500 scm³ per minute per 100mm of the web's width.

In a further subsidiary aspect, the web is coated to achieve an optical density (OD) of 2.2 and the flow rate of oxygen is within the range of 350 and 450 scm³ per minute per 100mm of the web's width.

In a subsidiary aspect, the flow rate of oxygen is within the range of 300-700 scm3 per minute per 100 mm of the web's width.

The claimed method is particularly advantageous because it provides a metallised coated substrate with advantageously high metal adhesion which enables its use for higher margin packaging structures. The position of the oxygen injector in particular allows for the creation of an oxygen rich metal oxide layer between the web surface and the remaining depth of the metal layer, which potentially increases the adhesion to levels greater than 5N/15mm whilst achieving advantageous opacity.

Moreover, this configuration simplifies the overall process as there is just one step rather than multiple steps. The position of the oxygen injector also improves the optical uniformity.

In a subsidiary aspect, the method comprises the step of injecting oxygen onto said web before any metal oxide is deposited onto said web.

In a subsidiary aspect, the method comprises the step of depositing a layer of metal oxide and a layer of metal; wherein the layer of metal oxide is thinner than the layer of metal.

The invention provides a method of operating a vacuum coater comprising the step of injecting oxygen at a tangent to the drum.

This configuration is particularly advantageous because, in use, this specific location provides improvements in metal adhesion levels whilst allowing the coating to achieve high levels of opacity. Moreover, this position is important as it prevents an increase in pressure within the vacuum.

### Brief Description of the Drawings

Figure 1 shows an underneath view of an embodiment of the oxygen injector in the vacuum deposition region.
Figure 2 shows an underneath view of an alternative embodiment of the oxygen injector in the vacuum deposition region.
Figure 3 shows a schematic side view of the vacuum coater in accordance with an embodiment of the invention.
Figure 4 shows a schematic side view of the oxygen injector in accordance with an embodiment of the invention including a shutter.

### Detailed Description of the Figures.

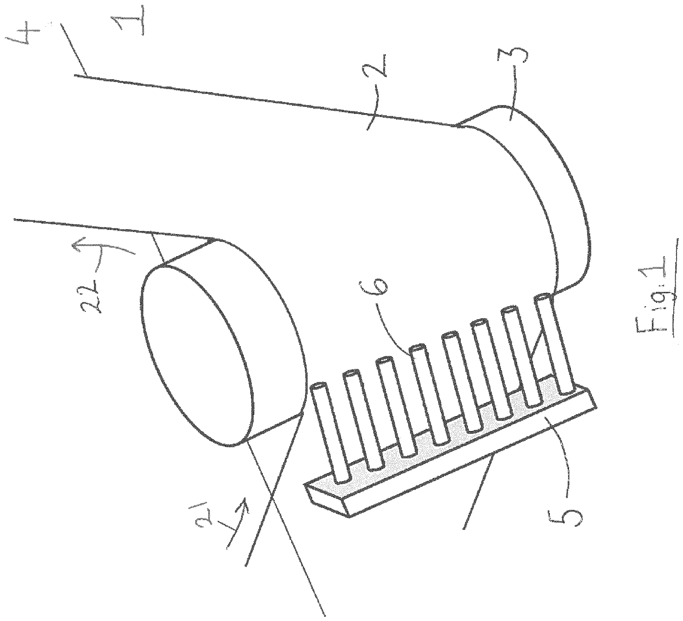

Figure 1 shows an embodiment of the vacuum coater viewed from the inside of the vacuum deposition chamber 1. The web sheet 2 to be deposited with metal is stretched over roller 3 which is located partially within the vacuum deposition chamber and partially within the main body of the metal coater 4.

In a preferred embodiment, the web is a polymeric web. In an alternative preferred embodiment the web is a metallic web such as aluminium foil.

As shown in the embodiment in Figure 1, an oxygen injector 5 comprises a plurality of individual pipe outlets 6 which deliver the oxygen directly onto the web 2 as it is transported around the roller 3. The oxygen injector outlets are located closely contiguous to the web sheet as shown in Figure 1. In a preferred embodiment, the pipe outlets have a pitch of 100mm. Figure 1 also shows the location of the oxygen injector tangential to the lowest mid-point of the roller 3. In further embodiment, the pipe outlets may be oriented in a line which would be parallel to this tangent but offset upwards.

Arrows 21 and 22 show the direction that the web moves in when the vacuum coater is in use. The location of the oxygen injector 5 within the vacuum deposition chamber allows the web to be exposed to oxygen both prior to and during the metal deposition and therefore creates an oxygen-rich metal oxide layer between the web surface and a remaining depth of deposited metal. As the web is displaced the oxygen is used up by the aluminium thus allowing an aluminium layer to be deposited over said oxide layer. The carefully restricted quantities of oxygen injecting in combination with the location of its injection are particularly advantageous in achieving this effect. Resulting from this approach as has been detailed above both high adhesion and improvements in surface tension may be achieved in most embodiments.

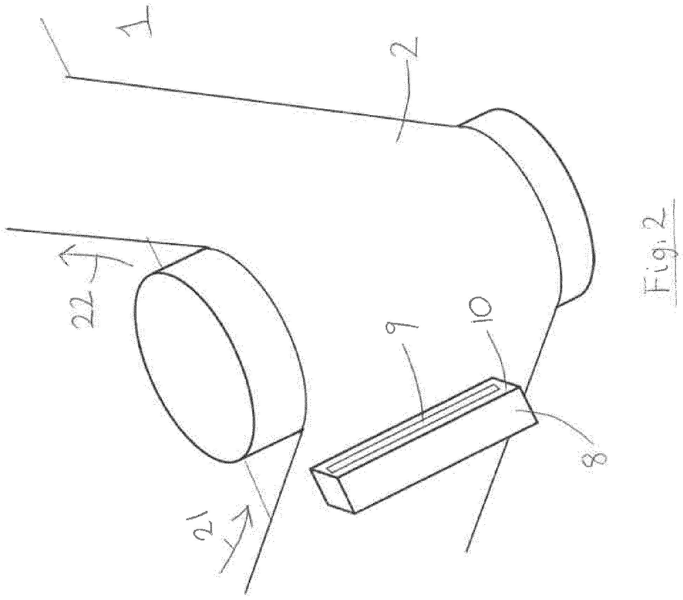

Figure 2 shows an alternative embodiment of the invention wherein the oxygen injector outlet is a single wedge - shaped bar 8 with an aperture 9 located at the narrowing edge 10. In use, the oxygen exits the outlet though aperture 9 directly onto the web sheet 2. The location of the oxygen injector is at the entrance of the web to the vacuum deposition chamber 1.

In preferred embodiments, the location of the injectors is optimised dependent on the aperture of the coater which defines the extent of the evaporated metal cloud. In preferred embodiments, the injectors inject at or just before the boundary of the metal cloud. In certain embodiments both the position of the injectors and the size of the aperture may be varied. Respective actuators may be provided to displace these as appropriate.

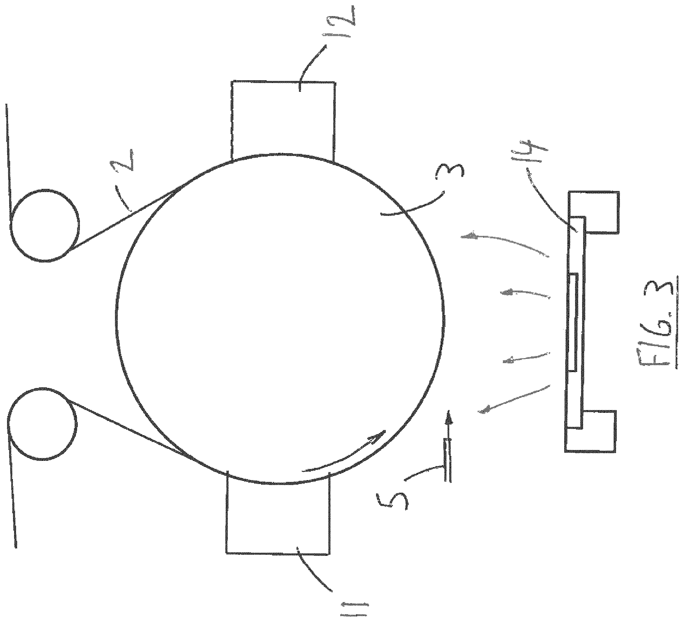

Figure 3 shows a schematic side view of the vacuum coater. Two seals 11 and 12 can be seen either side of the main roller 3 immediately adjacent to it. The location of the deposition source 14 is shown below the roller 3.

The oxygen injector 5 is closely contiguous with one of said seals and can be seen to be substantially tangential to the lowest mid-point of the roller 3 or slightly offset but parallel to the tangent as described in certain preceding embodiments.

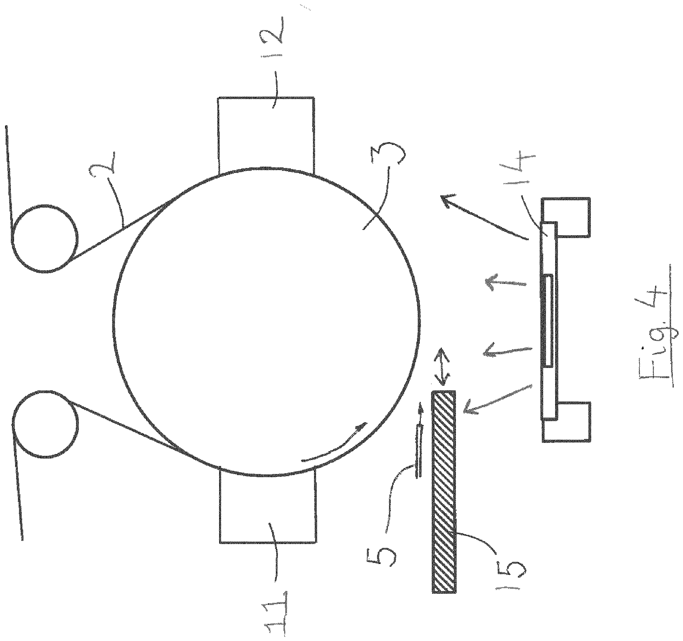

Figure 4 shows the same view including a static shield or a displaceable shutter 15 which, in use, prevents the oxygen injector nozzle from becoming blocked by deposits from the aluminium cloud. The shutter also acts to shield the deposition source to a greater or lesser extent. The shutter 15 is located at a position in which it extends past the oxygen injector. In this way it is able to prevent blockage of the nozzles.

In use, the oxygen is deposited on to the web sheet at its interface both immediately prior to and during the metal deposition within the vacuum chamber. This creates an oxygen rich metal oxide layer between the web surface and the remaining depth of the metal layer. In an embodiment of the invention, the remaining depth of the metal layer is typically 10-60nm.

In a preferred embodiment, the flow rate of oxygen is within the range of 300-700 scm³ per minute per 100 mm of the web's width.

In a preferred embodiment, the flow rate of oxygen is within the range of 300-500 scm³ per minute per 100 mm of the web's width.

In alternative preferred embodiments, the flow rate of oxygen may be within the range of 350-400scm³ per minute per 100mm of the web's width.

In a preferred embodiment, the amount of oxygen used in combination with the position of the oxygen injector, has a negligible effect on the vacuum level.

In an alternative embodiment, the invention can be used in conjunction with plasma pretreatment techniques to further increase metal adhesion. In this optional configuration, the plasma pre-treater may be provided in an unwind region prior to the film entering the deposition channel.

In a further embodiment, the web comprises polyethylene terephthalate (PET).

In a further embodiment, the web comprises biaxially oriented polypropylene (BOPP).

In a further embodiment, the web comprises cast polypropylene (CPP).

In a further embodiment, the flow rate of oxygen is within the range of 200-600 scm³ per minute per 100mm of the web's width and the web comprises polyethylene terephthalate (PET). Advantageously high adhesion rates are obtained for PET within this range.

In a further embodiment, the web is coated to achieve an optical density (OD) of between 2.2 and 2.6 and the flow rate of oxygen is within the range of 200 and 400 scm³ per minute per 100mm of the web's width.

In a further embodiment, the web is coated to achieve an optical density (OD) of between 2.2 and 2.6 and the flow rate of oxygen is within the range of 275 and 325 scm³ per minute per 100mm of the web's width.

In a further embodiment, the web is coated to achieve an optical density (OD) of 2.4 and the flow rate of oxygen is 300 scm³ per minute per 100mm of the web's width.

In a further embodiment, the web is coated to achieve an optical density (OD) of between 2.6 and 3 and the flow rate of oxygen is within the range of 325 and 425 scm³ per minute per 100mm of the web's width.

In a further embodiment, the web is coated to achieve an optical density (OD) of 2.8 and the flow rate of oxygen is between 375 and 425 scm³ per minute per 100mm of the web's width.

In a further embodiment, the web is coated to achieve an optical density (OD) of between 3 and 3.4 and the flow rate of oxygen is within the range of 400 and 500 scm³ per minute per 100mm of the web's width.

In a further embodiment, the web is coated to achieve an optical density (OD) of 3.2 and the flow rate of oxygen is between 450 and 500 scm³ per minute per 100mm of the web's width.

In a further embodiment, the flow rate of oxygen is within the range of 100-300 scm³ per minute per 100mm of the web's width and the web comprises biaxially oriented polypropylene (BOPP).

In a further embodiment, the web is coated to achieve an optical density (OD) of between 2 and 2.4 and the flow rate of oxygen is within the range of 150 and 200 scm³ per minute per 100mm of the web's width.

In a further embodiment, the web is coated to achieve an optical density (OD) of 2.2 and the flow rate of oxygen is within the range of 150 and 200 scm³ per minute per 100mm of the web's width.

In a further embodiment, the flow rate of oxygen is within the range of 300-500 scm3 per minute per 100mm of the web's width and the web comprises cast polypropylene (CPP).

In a further embodiment, the web is coated to achieve an optical density (OD) of between 2 and 2.4 and the flow rate of oxygen is within the range of 300 and 500 scm³ per minute per 100mm of the web's width.

In a further embodiment, the web is coated to achieve an optical density (OD) of 2.2 and the flow rate of oxygen is within the range of 350 and 450 scm³ per minute per 100mm of the web's width.

## Claims

1. A method of operating a vacuum coater (4) for coating a web with a succession of aluminium oxide and aluminium metal; said vacuum coater comprising a vacuum deposition region (1) with a deposition source (14) of aluminium for creating a vapour cloud and a drum (3); said method comprising the steps of providing a web about at least part of the circumference of said drum to allow a succession of aluminium oxide and aluminium metal to be deposited onto the web's surface; **characterized in that**
the coater further comprises an oxygen injector (5, 8) linearly extended along the width direction of the web; said method comprising providing said oxygen injector in close proximity to the web's entrance to the vacuum deposition region and relatively distant to the web's exit from the vacuum deposition region and comprising the step of injecting oxygen at a tangent to said drum; exposing the web to oxygen sufficiently prior to and during deposition of aluminium metal to oxygenate the surface of the web to cause aluminium oxide to be deposited on the web prior to and during the deposition of aluminium metal and further depositing evaporated aluminium metal over said aluminium oxide to form a layer of sufficient opacity to provide a UV light barrier of deposited aluminium metal.

2. A method according to claim 1, further comprising the step of injecting oxygen at a location closely contiguous to the web entrance to the vacuum deposition region.

3. A method according to either claim 1 or claim 2, comprising the step of exposing said web to oxygen at a flow rate within the range of 300-500 scm³ per minute per 100 mm of the web's width.

4. A method according to any one of claims 1 to 3, comprising the step of exposing said web to oxygen at a flow rate within the range of 350-400 scm³ per minute per 100 mm of the web's width.

## Patentansprüche

1. Verfahren zum Betreiben eines Vakuumbeschichters (4), um eine Bahn mit einer Abfolge aus Aluminiumoxid und Aluminiummetall zu beschichten, wobei der Vakuumbeschichter eine Vakuumabscheideregion (1) mit einer Quelle zum Abscheiden (14) von Aluminium, um eine Dampfwolke und eine Walze (3) zu erzeugen; wobei das Verfahren die Schritte des Bereitstellens einer Bahn mindestens um einen Teil des Umfangs der Walze herum umfasst, um zu ermöglichen, dass eine Abfolge aus Aluminiumoxid und Aluminiummetall auf der Oberfläche der Bahn abgeschieden wird;
**dadurch gekennzeichnet, dass**
der Beschichter weiter einen Sauerstoffinjektor (5, 8) umfasst, der sich linear entlang der Breitenrichtung der Bahn erstreckt; wobei das Verfahren das Bereitstellen des Sauerstoffinjektors in enger Nähe zum Eintritt der Bahn in die Vakuumabscheideregion und relativ weit vom Austritt der Bahn aus der Vakuumabscheideregion entfernt, und den Schritt des Einspritzens von Sauerstoff tangential zur Walze umfassend; vor und während dem Abscheiden von Aluminiummetall das ausreichende Aussetzen der Bahn gegenüber Sauerstoff, um die Oberfläche der Bahn mit Sauerstoff anzureichern, um zu bewirken, dass vor und während dem Abscheiden von Aluminiummetall Aluminiumoxid auf der Bahn abgeschieden wird, und weiter das Abscheiden von verdampftem Aluminiummetall über dem Aluminiumoxid umfasst, um eine Schicht von ausreichender Lichtundurchlässigkeit zu bilden, um eine UV-Licht-Barriere aus abgeschiedenem Aluminiummetall bereitzustellen.

2. Verfahren nach Anspruch 1, das weiter den Schritt des Einspritzens von Sauerstoff an einer Stelle umfasst, die eng an den Eintritt der Bahn in die Vakuumabscheideregion angrenzt.

3. Verfahren nach entweder Anspruch 1 oder Anspruch 2, das den Schritt des Aussetzens der Bahn gegenüber Sauerstoff mit einer Strömungsrate im Bereich von 300-500 Nm³ pro Minute pro 100 mm Breite der Bahn umfasst.

4. Verfahren nach einem der Ansprüche 1 bis 3, das den Schritt des Aussetzens der Bahn gegenüber Sauerstoff mit einer Strömungsrate im Bereich von 350-400 Nm³ pro Minute pro 100 mm Breite der Bahn umfasst.

## Revendications

1. Procédé de fonctionnement d'une coucheuse à vide (4) pour recouvrir une bande avec une succession d'oxyde d'aluminium et d'aluminium métallique ; ladite coucheuse à vide comprenant une région de dépôt sous vide (1) avec une source de dépôt (14) d'aluminium pour créer un nuage de vapeur et un tambour (3) ; ledit procédé comprenant les étapes consistant à fournir une bande autour d'au moins une partie de la circonférence dudit tambour pour permettre à une succession d'oxyde d'aluminium et d'aluminium métallique d'être déposée sur la surface de la bande ;
**caractérisé en ce que**
la coucheuse comprend en outre un injecteur d'oxygène (5, 8) s'étendant linéairement le long de la direction de largeur de la bande ; ledit procédé comprenant la fourniture dudit injecteur d'oxygène à proximité immédiate de l'entrée de la bande dans la région de dépôt sous vide et relativement éloigné de la sortie de la bande de la région de dépôt sous vide et comprenant l'étape consistant à injecter de l'oxygène tangentiellement par rapport audit tambour; l'exposition de la bande à l'oxygène de manière suffisante avant et pendant le dépôt d'aluminium métallique pour oxygéner la surface de la bande pour amener un oxyde d'aluminium à se déposer sur la bande avant et pendant le dépôt d'aluminium métallique et en outre le dépôt d'aluminium métallique évaporé sur ledit oxyde d'aluminium pour former une couche suffisamment opaque pour fournir une barrière anti-UV d'aluminium métallique déposé.

2. Procédé selon la revendication 1, comprenant en outre l'étape consistant à injecter de l'oxygène à un emplacement immédiatement contigu à l'entrée de la bande dans la région de dépôt sous vide.

3. Procédé selon la revendication 1 ou la revendication 2, comprenant l'étape consistant à exposer ladite bande à de l'oxygène à un débit dans la plage de 300-500 scm³ par minute pour 100 mm de largeur de la bande.

4. Procédé selon l'une quelconque des revendications 1 à 3, comprenant l'étape consistant à exposer ladite bande à de l'oxygène à un débit dans la plage de 350-400 scm³ par minute pour 100 mm de largeur de la bande.
